(19) Europäisches Patentamt
European Patent Office
Office européen des brevets

(11) **EP 2 384 542 B1**

(12) **EUROPÄISCHE PATENTSCHRIFT**

(45) Veröffentlichungstag und Bekanntmachung des Hinweises auf die Patenterteilung:
**10.10.2012  Patentblatt 2012/41**

(21) Anmeldenummer: **10702865.6**

(22) Anmeldetag: **03.02.2010**

(51) Int Cl.:
**H03B 5/24** (2006.01)    **H03B 5/18** (2006.01)

(86) Internationale Anmeldenummer:
**PCT/EP2010/051269**

(87) Internationale Veröffentlichungsnummer:
**WO 2010/091982 (19.08.2010 Gazette 2010/33)**

(54) **OSZILLATOR MIT OHMSCH EINSTELLBARER SCHWINGFREQUENZ**

OSCILLATOR HAVING AN OHMICALLY ADJUSTABLE OSCILLATING FREQUENCY

OSCILLATEUR AVEC FRÉQUENCE D'OSCILLATION COMMANDÉE PAR UNE RÉSISTANCE OHMIQUE

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(30) Priorität: **10.02.2009  DE 102009008225**

(43) Veröffentlichungstag der Anmeldung:
**09.11.2011  Patentblatt 2011/45**

(73) Patentinhaber: **Fraunhofer-Gesellschaft zur Förderung der angewandten Forschung e.V.
80686 München (DE)**

(72) Erfinder:
• **WEBER, Rainer
77652 Offenburg (DE)**
• **KALLFASS, Ingmar
F-67000 Strasbourg (FR)**

(74) Vertreter: **Stöckeler, Ferdinand et al
Schoppe, Zimmermann, Stöckeler & Zinkler
Patentanwälte
Postfach 246
82043 Pullach bei München (DE)**

(56) Entgegenhaltungen:
**US-A- 5 187 451      US-A1- 2007 075 799
US-A1- 2007 188 256**

EP 2 384 542 B1

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die vorliegende Anmeldung bezieht sich auf einen Oszillator mit ohmsch einstellbarer Schwingfrequenz.

Oszillatoren sind Schaltungen zur Erzeugung von hochfrequenten Schwingungen. Der Kern eines Oszillators ist ein aktives Bauelement mit einer nichtlinearen Kennlinie, wie beispielsweise ein Transistor oder eine Diode. Die Schwingfrequenz f des Oszillators wird über einen Schwingkreis und deren wirksame Kapazität C und Induktivität L vorgegeben:

$$f = \frac{1}{2 \cdot \pi \cdot \sqrt{L \cdot C}}$$

Der Schwingkreis, der auch als Resonator bezeichnet werden kann, kann mit allen frequenzselektiven Bauelementen realisiert werden, deren Verhalten sich mit einem Ersatzschaltbild aus Kapazität und Induktivität beschreiben lässt. Beispiele hierfür sind diskrete LC-Schwingkreise, dielektrische Resonatoren, Hohlraumresonatoren oder Leitungsresonatoren.

Neben Festfrequenz-Oszillatoren mit nur einer Schwingfrequenz gibt es noch Oszillatoren, die sich in ihrer Schwingfrequenz verändern lassen Siehe zum Beispiel US 4003000 . Die Schwingfrequenz lässt sich variieren, indem frequenzbestimmende Bauteile des Schwingkreises mechanisch oder elektrisch verändert werden. Mechanisch veränderbare Bauelemente scheiden bei vielen Anwendungen aus, bei denen es auf eine schnelle Frequenzänderung ankommt. Für derartige Anwendungen werden spannungsgesteuerte Bauteile im Oszillator verwendet. Werden spannungsgesteuerte Bauteile in Oszillatoren verwendet, spricht man von spannungsgesteuerten Oszillatoren bzw. VCOs (voltage controlled oscillators). Bei bisherigen VCO-Konzepten wird die spannungsabhängige Sperrschichtkapazität von Varaktor-Dioden oder die spannungsgesteuerte Kapazität eines Transistors ausgenutzt, um die wirksame Kapazität des Resonators zu verändern und somit die Schwingfrequenz des Oszillators zu variieren.

Ein generelles Problem von monolithisch integrierten Schaltkreisen ist die Abhängigkeit von einer bestimmten Technologie und deren Transistorarchitektur. So sind Transistoren für den Millimeterwellenbereich auf Schnelligkeit optimiert, woraus sich jedoch keine Varaktor-Dioden mit optimalen Eigenschaften realisieren lassen. Darüber hinaus besitzen monolithisch integrierte VCOs, die mit Varaktor-Dioden arbeiten, häufig eine Bandbreite von 5 bis 8%, bezogen auf die mittlere Schwingfrequenz. Eine höhere Bandbreite von beispielsweise mehr als 10% ist mit monolithisch integrierten Varaktor-Dioden mit einem erhöhten Aufwand und Komplexität verbunden.

Die Aufgabe der vorliegenden Erfindung besteht darin, einen Oszillator mit einstellbarer Schwingfrequenz zu schaffen, der hohe Durchstimmbandbreiten ermöglicht.

Diese Aufgabe wird durch einen Oszillator gemäß Anspruch 1 gelöst.

Ausführungsbeispiele der Erfindung schaffen einen Oszillator mit einstellbarer Schwingfrequenz, mit folgenden Merkmalen:

einem aktiven Bauelement, das an einem Anschluss einen negativen Eingangswiderstand zeigt;

einem Schwingkreis, der mit dem Anschluss des aktiven Bauelements, das den negativen Eingangswiderstand zeigt, gekoppelt ist; und

einem Element mit einstellbarem ohmschen Widerstand, durch das die Schwingfrequenz des Oszillators einstellbar ist.

Bei Ausführungsbeispielen der Erfindung kann durch das Element mit einstellbarem ohmschen Widerstand die Impedanz des Schwingkreises und/oder die Impedanz einer Schaltungsstruktur, mit der das aktive Element geschaltet ist, um den negativen Eingangswiderstand zu erzeugen, variiert werden. Bei Ausführungsbeispielen kann durch das Element mit einstellbaren ohmschen Widerstand die wirksame Länge einer Resonatorleitung, die den Schwingkreis bildet, eingestellt werden, um dadurch die Resonanzfrequenz des Oszillators einzustellen. Bei Ausführungsbeispielen der Erfindung kann das Element mit einstellbarem ohmschen Widerstand ein Transistor sein, dessen ohmscher Widerstand über seine Steuerspannung eingestellt werden kann. Bei Ausführungsbeispielen der Erfindung kann die Schwingfrequenz des Oszillators stufenlos einstellbar sein.

Ausführungsbeispiele der vorliegenden Erfindung ermöglichen höhere Durchstimmbandbreiten eines Oszillators mit einstellbarer Schwingfrequenz als sie mit herkömmlichen Verfahren erreicht werden können. Die vorliegende Erfindung ist somit insbesondere interessant für monolithisch integrierte VCOs im Millimeter- und Sub-Millimeter-Wellenbereich ab 30 GHz, bei denen eine große Durchstimmbandbreite benötigt wird. Gerade bei Radarsystemen besteht ein direkter Zusammenhang von Bandbreite und Ortsauflösung.

Das erfindungsgemäße Konzept ermöglicht vorteilhaft eine Integration von Oszillatoren mit bereits bestehenden Sende- /Empfangsschaltungen und Radarschaltungen auf einem Chip. Dadurch kann der Aufwand für den Aufbau sinken und Komplettsysteme können kleiner, leichter und energiesparender implementiert werden, was wiederum den Preis senken kann.

Ausführungsbeispiele der Erfindung schaffen somit spannungsgesteuerte Oszillatoren (VCOs), die als frequenzbestimmendes Bauteil ein ohmisch durchstimmbares Element bzw. einen spannungsgesteuerten Widerstand verwenden. Bei Ausführungsbeispielen wird als frequenzbestimmendes Bauteil ein Transistor in Parallelschaltung verwendet. Bei Ausführungsbeispielen ist das Element mit einstellbarem ohmschen Widerstand verschaltet, um durch das Ändern des ohmschen Widerstandes desselben die wirksame elektrische Länge oder die Impedanz einer Hochfrequenzleitung zu verändern. Allgemein kann ein Element mit einstellbarem ohmschen Widerstand in irgendeiner Zuleitung des Transistors verwendet werden, um damit das Verhalten des Transistors in der Hinsicht zu beeinflussen, dass sich die Resonanzfrequenz des Oszillators durch eine Änderung des ohmschen Widerstands verändert. Bei Ausführungsbeispielen kann der Oszillator nur zwei diskrete Schwingfrequenzen besitzen, indem das Element mit einstellbarem ohmschen Widerstand zwischen zwei Extremwerten umschaltbar ist. Durch dieses Umschalten kann bei Ausführungsbeispielen zwischen zwei Extremwerten der einstellbaren elektrischen Länge oder Impedanz eine Hochfrequenzleitung umgeschaltet werden.

Ausführungsbeispiele der Erfindung werden nachfolgend Bezug nehmend auf die beiliegenden Zeichnungen, in denen gleiche oder gleichwirkende Elemente mit gleichen Bezugszeichen bezeichnet sind, näher erläutert. Es zeigen:

Fig. 1 ein erstes Ausführungsbeispiel eines erfindungsgemäßen Oszillators;

Fig. 2 ein zweites Ausführungsbeispiel eines erfindungsgemäßen Oszillators; und

Fig. 3 ein drittes Ausführungsbeispiel eines erfindungsgemäßen Oszillators.

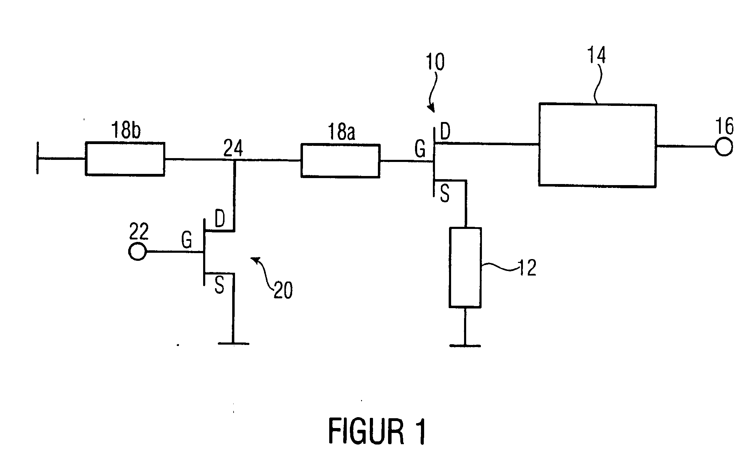

Bei dem in Fig. 1 gezeigten Ausführungsbeispiel umfasst der Oszillator ein aktives Element in Form eines Feldeffekttransistors 10. Der Source-Anschluss S des Feldeffekttransistors 10 ist über ein Element 12 zur Erzeugung einer Instabilität mit einem Bezugspotential, beispielsweise Masse, verbunden. Der Drainanschluss D des Feldeffekttransistors 10 ist über ein Impedanzanpassnetzwerk 14 mit einem Ausgang 16 des Oszillators verbunden.

Das Element 12 zur Erzeugung einer Instabilität ist ausgelegt, um an einem Gateanschluss G des Feldeffekttransistors 10 einen negativen Eingangswiderstand bereitzustellen.

Mit dem Gate-Anschluss G des Feldeffekttransistors 10 verbunden ist ein Leitungsresonator, der Resonatorleitungsabschnitte 18a und 18b aufweist. Der Leitungsresonator stellt einen Schwingkreis, der mit dem Gateanschluss G gekoppelt ist, dar.

Leitungsresonatoren können durch kurzgeschlossene oder offene Hochfrequenzleitungen implementiert sein, an deren Ende hochfrequente Energie reflektiert wird, so dass sich eine stehende Welle bildet. Die Resonanzfrequenz des Oszillators ist dabei von der Länge der Resonatorleitung abhängig. Eine lange Leitung bewirkt eine niedrigere und eine kurze Leitung eine hohe Schwingfrequenz. Entsprechend kann der Leitungsresonator bzw. können die Resonatorleitungsabschnitte bei Ausführungsbeispielen der Erfindung als kurzgeschlossene oder offene Hochfrequenzleitungen implementiert sein.

Der Oszillator weist ferner einen weiteren Feldeffekttransistor 20 auf, der ein Element mit einstellbarer ohmscher Impedanz darstellt. Genauer gesagt ist der ohmsche Widerstand zwischen dem Drainanschluss und dem Sourceanschluss des Transistors 20 über ein Variieren der Spannung am Gateanschluss G des Transistors 20 über einen Steueranschluss 22 einstellbar.

Das ohmisch variable Element, das durch den Transistor 20 gebildet ist, ist zwischen einen Abgriff 24 zwischen den Resonatorleitungsabschnitten 18a und 18b und ein Referenzpotential, beispielsweise Masse, geschaltet. Dieses Element 22 stellt somit einen Transistor in Parallelschaltung, einen sog. Shunt-Transistor, dar.

Der Transistor 20 ermöglicht, abhängig von einer Steuerspannung an dem Steueranschluss 22, einen variablen Stromfluss von dem Abgriff 24 gegen das Bezugspotential. Dadurch kann die wirksame Länge und Impedanz des Leitungsresonators, der mit dem Gate des Transistors 10 verbunden ist, über die Steuerspannung des Transistors 20 geändert werden.

In einem Extremfall ist bei leitendem Transistor 22 der Signalleiter der Resonatorleitung an der Stelle des Abgriffs 24 kurzgeschlossen und die reduzierte Resonatorlänge des Resonatorleitungsabschnitts 18a ist wirksam. Im entgegengesetzten Extremfall ist die gesamte Länge der Resonatorleitung, das heißt die kombinierte Länge der Resonatorleitungsabschnitte 18a und 18b wirksam, wenn sich der Transistor 20 im offenen Zustand befindet.

Im Betrieb kann der Oszillator in Fig. 1 beispielsweise über das Anpassnetzwerk 14 mit Leistung versorgt werden, wobei am Ausgang 16 ein Oszillatorausgangssignal mit einer Schwingfrequenz erzeugt wird. Eine Leistungsversorgung kann beispielsweise durch eine Verbindung des Drain-Anschlusses des Feldeffekttransistors 10 mit einem Versorgungsspannungspotential über eine Drosselspule implementiert sein. Die Schwingfrequenz des Ausgangssignals ist über ein Verändern der Steuerspannung des Transistors 20 einstellbar. Beispielsweise kann es zwischen zwei Schwingfrequenzen umgeschaltet werden, indem der Transistor 20 ein- oder ausgeschaltet wird. Alternativ kann eine Feinabstimmung der Schwingfrequenz erfolgen, indem der Widerstand des Transistors auf entsprechende Zwischenwerte gesteuert wird.

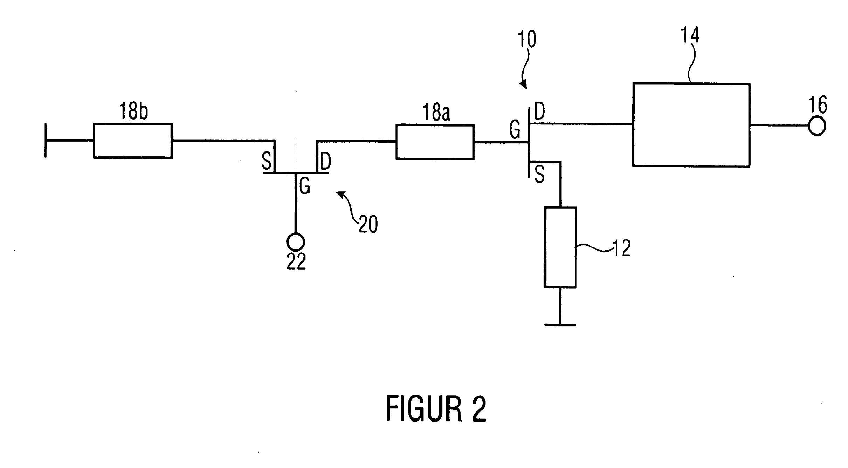

Fig. 2 zeigte ein alternatives Ausführungsbeispiel, bei dem der Transistor 20 nicht als Transistor in Parallelschaltung verschaltet ist, sondern seriell zwischen die beiden Resonatorleitungsabschnitte 18a und 18b geschaltet ist. Auch hier kann durch Variieren der Steuerspannung am Steueranschluss 22 die wirksame Länge bzw. Impedanz der Resonatorleitung_und somit die Schwingfrequenz eingestellt werden. Die Impedanz des Transistors ist wiederum zwischen einem offenen Zustand und einem leitenden Zustand variierbar. Im offenen Zustand des Transistors 20 ist nur die Länge des Resonatorleitungsabschnitts 18a wirksam, während im leitenden Zustand die Länge beider Resonatorleitungsabschnitte 18a und 18b wirksam ist. Somit kann auch bei dem in Fig. 2 gezeigten Ausführungsbeispiel über ein Steuern des Widerstands des Transistors 20 die Schwingfrequenz des Oszillatorsignals am Ausgang 16 eingestellt werden.

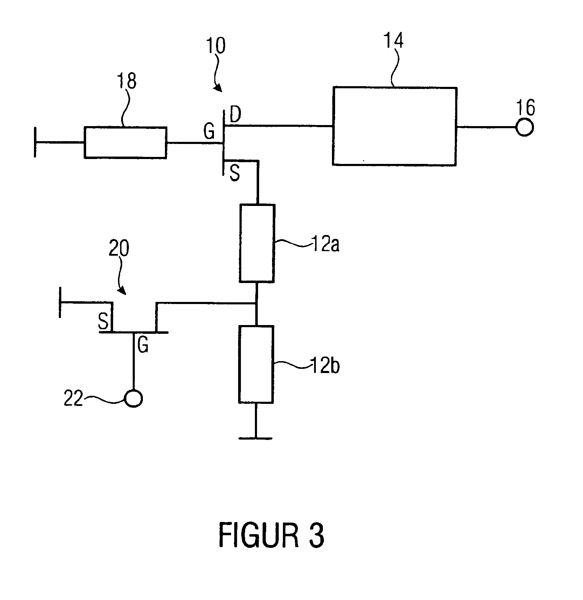

Bei den in den Fig. 1 und 2 gezeigten Ausführungsbeispielen ist das Element mit einstellbarem ohmschen Widerstand vorgesehen, um die Impedanz des Schwingkreises des Oszillators zu variieren. Fig. 3 zeigt ein alternatives Ausführungsbeispiel, bei dem ein Element mit einstellbarem ohmschen Widerstand, das wiederum durch einen Transistor 20 gebildet ist, vorgesehen ist, um die Impedanz der Schaltungsstruktur, die für das Erzeugen des negativen Eingangswiderstands des aktiven Elements 10 verantwortlich ist, zu variieren. Auch dadurch kann die Schwingfrequenz des Oszillatorsignals am Ausgang 16 eingestellt werden.

Bei dem in Fig. 3 gezeigten Ausführungsbeispiel ist ein Leitungsresonator 18 mit dem Gateanschluss des aktiven Elements 10 verbunden. Der Drainanschluss D ist wiederum über das Anpassnetzwerk 14 mit dem Ausgang 16 verbunden. Der Sourceanschluss ist über eine Hochfrequenzleitung, die Leitungsabschnitte 12a und 12b aufweist, mit einem Bezugspotential, beispielsweise Masse verbunden.

Das Element mit einstellbarem ohmschen Widerstand 20 ist zwischen einen Abgriff 30 zwischen den Leitungsabschnitten 12a und 12b und ein Bezugspotential, beispielsweise Masse, geschaltet. Durch ein Ändern der Steuerspannung an dem Steueranschluss 22 ist wiederum die ohmsche Impedanz, die zwischen dem Abgriff 30 und dem Bezugspotential vorliegt, einstellbar, so dass dadurch die Impedanz des zwischen den Source-Anschluss des Transistors 10 und das Bezugspotential geschalteten Schaltungsstruktur einstellbar ist. Dadurch ist wiederum die Schwingfrequenz des Oszillatorsignals am Ausgang 16 einstellbar.

In der obigen Beschreibung von Ausführungsbeispielen der Erfindung wurde jeweils auf Leitungsabschnitte 18a, 18b bzw. 12a und 12b Bezug genommen. Diese Leitungsabschnitte können durch separate Hochfrequenzleitungen gebildet sein oder durch eine einzige Hochfrequenzleitung, die an geeigneter Stelle, beispielsweise mittig, einen entsprechenden Abgriff aufweist. Bei Ausführungsbeispielen der Erfindung können die Resonatorleitungen bzw. Resonatorleitungsabschnitte beispielsweise durch Mikrostreifenleitungen oder Koplanarleitungen gebildet sein.

Für monolithisch integrierte Oszillatoren für den Millimeterwellenbereich (30 bis 300 GHz) werden vorteilhaft Leitungsresonatoren statt Schwingkreisen aus Kapazitäten und Induktivitäten eingesetzt, weil sich insbesondere Induktivitäten für diesen Frequenzbereich nur schwer realisieren lassen. Bei alternativen Ausführungsbeispielen kann der Schwingkreis jedoch auch durch diskrete kapazitive und induktive Elemente implementiert sein. Auch in einem solchen Fall können ein oder mehrere Elemente mit einstellbarem ohmschen Widerstand, beispielsweise Transistoren, verwendet sein, um die Impedanz des Schwingkreises zu verändern, um dadurch die Schwingfrequenz des Oszillatorsignals einzustellen. Beispielsweise könnten bei Ausführungsbeispielen Transistorschalter verwendet werden, um Kapazitäten bzw. Induktivitäten in und aus einem Schwingkreis zu schalten, um somit die Impedanz des Schwingkreises zu variieren. Bezug nehmend auf die obigen Ausführungsbeispiele wurde jeweils nur ein Element mit einstellbarem ohmschen Widerstand beschrieben. Es ist für Fachleute offensichtlich, dass mehrere entsprechende Elemente vorgesehen sein können, beispielsweise um zwischen einer größeren Zahl als zwei effektiven Resonatorleitungslängen umzuschalten. Ferner können bei alternativen Ausführungsbeispielen Elemente mit einstellbarem ohmschen Widerstand vorgesehen sein, durch die sowohl die Impedanz des Schwingkreises als auch die Impedanz der zur Erzeugung des negativen Eingangswiderstands vorgesehenen Schaltstruktur variiert werden können.

Bei den beschriebenen Ausführungsbeispielen ist das Element mit einstellbarem ohmschen Widerstand durch einen Transistor gebildet. Alternativ kann als ein Element mit einstellbarem ohmschen Widerstand ein beliebiges ohmisch variables Element verwendet werden, beispielsweise eine Diode oder generell ein spannungsabhängiger Widerstand.

Die obigen Ausführungsbeispiele wurden Bezug nehmend auf Feldeffekttransistoren beschrieben. Es ist für Fachleute offensichtlich, dass statt Feldeffekttransitoren auch Bipolartransistoren verwendet werden können, wobei dann die Source-, Drain- und Gateanschlüsse jeweils entsprechend durch die Emitter-, Kollektor- und Basisanschlüsse zu ersetzen sind.

Bei den obigen Ausführungsbeispielen ist der Schwingkreis mit dem Steueranschluss (Gate-Anschluss oder Basis-Anschluss) des Transistors verbunden. Wie für Fachleute offensichtlich ist, kann abhängig von der verwendeten Konfiguration der Schwingkreis mit einem beliebigen Anschluss (Drain-Anschluss oder Source-Anschluss bzw. Kollektor-Anschluss oder Emitter-Anschluss) des Transistors, der einen negativen Eingangswiderstand zeigt, verbunden sein, solange die anderen Anschlüsse derart beschaltet sind, dass sich ein schwingfähiges System ergibt.

Implementierungen für das Anpassnetzwerk 14, um beispielsweise eine Anpassung auf eine 50-Ohm-Leitung zu liefern, und um eine Leistungsversorgung des Oszillators zu ermöglichen, sind für Fachleute offensichtlich und bedürfen hierin keiner weiteren Erläuterung. In gleicher Weise ist die Theorie von Oszillatoren, bei denen ein aktives Element an einem Anschluss, der mit einem Resonator beschaltet ist, einen negativen Widerstand bietet, Fachleuten bekannt. Geeignete Beschaltungen eines aktiven Elements, wie z.B. eines Feldeffekttransistors oder eines Bipolartransistors, mit einem Element zur Erzeugung einer Instabilität, wie z.B. einer Induktivität, einer Kapazität und/oder einer Hochfrequenzleitung, um einen solchen negativen Widerstand zu bieten, sind für einen Fachmann ersichtlich und bedürfen ebenfalls keiner weiteren Erläuterung.

Ausführungsbeispiele der vorliegenden Erfindung schaffen somit einen neuartigen Lösungsansatz, um die Schwingfrequenz eines VCOs zu variieren, wobei sich höhere Durchstimmbandbreiten realisieren lassen als bei konventionellen Verfahren. Ferner ermöglicht die vorliegende Erfindung eine hervorragende Integrationsmöglichkeit mit bestehenden Schaltungskonzepten, beispielsweise Sende-/Empfangsschaltungen und Radarschaltungen auf einem Chip, so dass Komplettsysteme kleiner, leichter und energiesparender mit geringem Aufwand implementiert werden können.

## Patentansprüche

1. Oszillator, mit spannungsgesteuert einstellbarer Schwingfrequenz, mit folgenden Merkmalen:

   einem aktiven Bauelement (10), das an einem Anschluss (G) einen negativen Eingangswiderstand zeigt;
   einem Schwingkreis (12, 18a, 18b; 12a, 12b, 18), der mit dem Anschluss (G) des aktiven Bauelements (10), der den negativen Eingangswiderstand zeigt, gekoppelt ist; und
   einem Element (20) mit spannungsgesteuert einstellbarem ohmschen Widerstand, durch das die Schwingfrequenz des Oszillators stufenlos einstellbar ist,
   **dadurch gekennzeichnet, dass**
   der Schwingkreis (12, 18a, 18b; 12a, 12b, 18) eine Resonatorleitung aufweist, wobei durch das Element (20) mit einstellbarem ohmschen Widerstand die zur Schwingungserzeugung wirksame Länge der Resonatorleitung (12a, 12b; 18a, 18b) einstellbar ist.

2. Oszillator nach Anspruch 1, bei dem durch das Element mit einstellbarem ohmschen Widerstand (20) die Impedanz des Schwingkreises (12, 18a, 18b; 12a, 12b, 18) einstellbar ist.

3. Oszillator nach Anspruch 1, bei dem das Element (20) mit einstellbarem ohmschen Widerstand zwischen einen Abgriff (24) der Resonatorleitung (12a, 12b; 18a, 18b) und ein Referenzpotential geschaltet ist.

4. Oszillator nach Anspruch 1, bei dem das Element (20) mit einstellbarem ohmschen Widerstand seriell zwischen Abschnitte (18a, 18b) der Resonatorleitung geschaltet ist.

5. Oszillator nach einem der Ansprüche 1 bis 4, bei dem das Element (20) mit einstellbarem ohmschen Widerstand einen Transistor aufweist.

6. Oszillator nach einem der Ansprüche 1 bis 5, bei dem das Element (20) mit einstellbarem ohmschen Widerstand zwei Zustände aufweist, zwischen denen dasselbe umschaltbar ist.

## Claims

1. Oscillator with an oscillation frequency adjustable in a voltage-controlled manner, comprising:

   an active device (10) showing a negative input resistance at a terminal (G);
   an oscillator circuit (12, 18a, 18b; 12a, 12b, 18) coupled to the terminal (G) of the active device (10) showing the negative input resistance; and
   an element (20) with an ohmic resistance adjustable in a voltage-controlled manner, by which the oscillation frequency of the oscillator can be continuously adjusted,
   **characterized in that**
   the oscillator circuit (12, 18a, 18b; 12a, 12b, 18) comprises a resonator line, wherein the length of the resonator line (12a, 12b; 18a, 18b) effective for oscillation generation is adjustable by the element (20) with adjustable ohmic resistance.

2. Oscillator according to claim 1, wherein the impedance of the oscillator circuit (12, 18a, 18b; 12a, 12b, 18) can be adjusted by the element with adjustable ohmic resistance (20).

3. Oscillator according to claim 1, wherein the element (20) with adjustable ohmic resistance is connected between a tap (24) of the resonator line (12a, 12b; 18a, 18b) and a reference potential.

4. Oscillator according to claim 1, wherein the element (20) with adjustable ohmic resistance is connected in series between portions (18a, 18b) of the resonator line.

5. Oscillator according to one of claims 1 to 4, wherein the element (20) with adjustable ohmic resistance comprises a transistor.

6. Oscillator according to one of claims 1 to 5, wherein the element (20) with adjustable ohmic resistance comprises two states between which the same can be switched.

## Revendications

1. Oscillateur à fréquence d'oscillation réglable commandée par la tension, aux caractéristiques suivantes:

   un composant actif (10) qui indique à une connexion (G) une résistance d'entrée négative;
   un circuit d'oscillation (12, 18a, 18b; 12a, 12b, 18) qui est couplé à la connexion (G) du composant actif (10) qui indique la résistance d'entrée négative; et
   un élément (20) à résistance ohmique réglable commandée par la tension, par lequel la fréquence d'oscillation de l'oscillateur est réglable sans paliers,
   **caractérisé par le fait que** le circuit d'oscillation (12, 18a, 18b; 12a, 12b, 18) présente une ligne de résonateur, par l'élément (20) à résistance ohmique réglable étant réglable la longueur active pour la génération d'oscillation de la ligne de résonateur (12a, 12b; 18a, 18b).

2. Oscillateur selon la revendication 1, dans lequel l'impédance du circuit d'oscillation (12, 18a, 18b; 12a, 12b, 18) est réglable par l'élément à résistance ohmique réglable (20).

3. Oscillateur selon la revendication 1, dans lequel l'élément (20) à résistance ohmique réglable est connecté entre une dérivation (24) de la ligne de résonateur (12a, 12b; 18a, 18b) et un potentiel de référence.

4. Oscillateur selon la revendication 1, dans lequel l'élément (20) à résistance ohmique réglable est connecté en série entre des segments (18a, 18b) de la ligne de résonateur.

5. Oscillateur selon l'une quelconque des revendications 1 à 4, dans lequel l'élément (20) à résistance ohmique réglable présente un transistor.

6. Oscillateur selon l'une quelconque des revendications 1 à 5, dans lequel l'élément (20) à résistance ohmique réglable présente deux états entre lesquelles il peut être commuté.

FIGUR 1

16 14 10 D G S 12 18a 24 20 D G S 22 18b

FIGUR 2

EP 2 384 542 B1

FIGUR 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 4003000 A